# EUROPÄISCHE PATENTSCHRIFT

(11) **EP 2 581 722 B1**
(45) Veröffentlichungstag und Bekanntmachung des Hinweises auf die Patenterteilung: **24.02.2016**
(21) Anmeldenummer: 12184039.1
(22) Anmeldetag: 12.09.2012
(51) Int. Cl.: G01L 19/06, B81C 1/00, G01L 9/00

(54) **Gegenkörper für eine Druckmesszelle, Druckmesszelle mit einem solchen Gegenkörper und Verfahren zu dessen Herstellung**
Opposing body for a pressure measuring cell, pressure measuring cell with such an opposing body and method for producing same
Élément complémentaire pour une cellule de mesure de pression, cellule de mesure de pression dotée d'un tel élément complémentaire et son procédé de fabrication

(30) Priorität: 13.10.2011 DE 102011084457
(43) Veröffentlichungstag der Anmeldung: 17.04.2013
(73) Patentinhaber: Endress + Hauser GmbH + Co. KG, 79689 Maulburg (DE)
(72) Erfinder: Alff, Lambert, 64285 Darmstadt (DE); Hildebrandt, Sandra, 64846 Groß-Zimmern (DE); Kober, Timo, 63128 Dietzenbach (DE); Teipen, Rafael, 10407 Berlin (DE); Tham, Anh Tuan, 10243 Berlin (DE); Werthschützky, Roland, 14532 Kleinmachnow (DE)
(74) Vertreter: Andres, Angelika Maria

(56) Entgegenhaltungen:
- WO-A1-2011/051089
- WO-A2-2006/082751
- DE-A1-102008 043 171
- CHANG-MING XU ET AL: "Amorphization of Cristobalite at High Temperature in Vacuum", JOURNAL OF MATERIALS RESEARCH, Bd. 20, Nr. 08, 1. August 2005 (2005-08-01), Seiten 1943-1946, XP055141633, ISSN: 0884-2914, DOI: 10.1557/JMR.2005.0266

## Beschreibung

Die vorliegende Erfindung betrifft eine Druckmesszelle mit einem Gegenkörper sowie ein Verfahren zu dessen Herstellung.

Druckmesszellen umfassen gewöhnlich mindestens einen Gegenkörper und eine Messmembran, welche mit dem Gegenkörper druckdicht gefügt ist, wobei die Messmembran ein Volumen in zwei Teilvolumina voneinander trennt, wobei die Messmembran in Abhängigkeit von der Differenz zwischen den in den beiden Teilvolumina herrschenden Drücken auslenkbar ist, wobei die Druckmesszelle ferner einen Wandler umfasst, um ein von der Verformung der Messmembran abhängiges Signal zu erzeugen.

Je nach der Art der beteiligten Drücke unterscheidet man insbesondere in der industriellen Prozessmesstechnik zwischen Absolut-, Relativ- und Differenzdruckmesszellen. Bei Absolut- und Relativdruckmesszellen wird jeweils ein Mediendruck gegen Vakuum bzw. Atmosphärendruck gemessen, während bei Differenzdruckmesszellen die Differenz zwischen einem ersten und einem zweiten Mediendruck zu bestimmen ist.

Insbesondere bei Differenzdruckmesszellen - aber nicht nur bei diesen - besteht die Gefahr, dass die Differenz zwischen den beteiligten Drücken so groß werden kann, dass die Messmembran zu stark ausgelenkt und dadurch beschädigt wird. Es gibt daher Bemühungen, einerseits die Druckdifferenz zwischen den Teilvolumina zu begrenzen, beispielsweise durch hydraulische Messwerke mit Überlastmembranen, und andererseits die Messmembran durch eine geeignete Kontur an dem Gegenkörper abzustützen, um eine weitere Auslenkung zu verhindern.

Die vorliegende Erfindung betrifft die letztgenannte Alternative. Eine geeignete Kontur soll dabei insbesondere die Biegelinie der Messmembran approximieren.

Die Offenlegungsschrift DE 10 2008 043 171 A1 offenbart einen Drucksensor, welcher eine Messmembran und einen Gegenkörper aus einem Borosilikatglas auf, wobei der Gegenkörper eine Membranbett aufweist, das durch Heißprägen präpariert ist.

Eine gattungsgemäßes Verfahren zum Präparieren solcher Konturen in Gegenkörpern aus Glas ist in der Offenlegungsschrift DE 10 2009 046 229 A1 offenbart. Im Wesentlichen werden die Konturen dabei durch thermisches Einsinken präpariert, wobei ein Glaskörper aus dem Gegenkörper zu fertigen sind auf einem Träger auf eine Temperatur oberhalb des Erweichungspunkt erwärmt wird, um nicht unterstützte Bereiche des Glaskörpers einsinken zu lassen. Die solchermaßen präparierten Gegenkörper sind tatsächlich geeignet, eine Messmembran, beispielsweise aus Silizium gut abzustützen.

Es hat sich gezeigt, dass sich durch den Prozess des thermischen Einsinkens an der Oberfläche des Glaskörpers Defekte ausbildeten, die einen Durchmesser von bis zu 25 µm aufweisen und um bis zu mehr als 100 nm aus der Oberfläche herausragen können. Derart defektbehaftete Oberflächen können zu lokalen Spannungsspitzen beim Fügen führen. Es ist daher erstrebenswert, die Defekte zu vermeiden.

Es ist daher die Aufgabe der Erfindung, hier Abhilfe zu schaffen.

Die Aufgabe wird erfindungsgemäß gelöst durch die Druckmesszelle gemäß dem unabhängigen Patentanspruch 1 und das Verfahren gemäß dem unabhängigen Patentanspruch 5.

Erfindungsgemäß ist die Glasoberfläche des Gegenkörpers im wesentlichen frei von Kristobalit-Kristallen, die einen Durchmesser von mehr als 5 µm aufweisen.

In einer Weiterbildung der Erfindung ergibt ein Fit einer Funktion der Form z(r)= z₀*(1-(r/r₀)²)² an die durch den planaren Randbereich begrenzte Kontur einen Wert von z₀, für den gilt: z₀/r₀ > 2*10⁻³, insbesondere z₀/r₀ > 3*10⁻³ und bevorzugt z₀/r₀ > 4*10⁻³, wobei r₀ ein effektiver äußerer Radius der Kontur ist.

Erfindungsgemäß ist die Kontur erhältlich durch ein Verfahren, welches thermisches Einsinken unter Vakuum umfasst.

Die erfindungsgemäße Druckmesszelle umfasst mindestens einen erfindungsgemäßen Gegenkörper und eine Messmembran, welche insbesondere mittels anodischen Bondens mit dem Gegenkörper gefügt ist.

In einer Weiterbildung der Erfindung ist die Druckmesszelle eine Differenzdruckmesszelle und umfasst weiterhin einen zweiten erfindungsgemäßen Gegenkörper, wobei die Messmembran zwischen dem ersten Gegenkörper und dem zweiten Gegenkörper angeordnet und mit beiden Gegenkörpern druckdicht gefügt ist.

In einer Welterbildung der Druckmesszelle weist die Messmembran Silizium auf.

Gemäß einer Weiterbildung des Verfahrens erfolgt das thermische Einsinken bei einer Temperatur oder Temperaturen, die nicht weniger als 200°C, insbesondere nicht weniger als 250°C und bevorzugt nicht weniger als 280°C über dem Erweichungspunkt des Glases liegt bzw liegen.

Gemäß einer Weiterbildung des Verfahrens dient es zum Herstellen einer Vielzahl von erfindungsgemäßen Gegenkörpern, wobei aus dem plattenförmigen Glaskörper, die Vielzahl der Gegenkörper zu präparieren ist, und wobei der Träger auf dem der Glaskörper zu positionieren ist, eine Vielzahl von Aussparungen oder Vertiefungen aufweist, über denen jeweils ein nicht unterstützter Bereich des Glaskörpers angeordnet ist, dessen plastische Verformung durch thermisches Einsinken erfolgt, um jeweils eine Kontur eines Gegenkörpers zu bilden.

Gemäß einer Weiterbildung des Verfahrens weisen die Vertiefungen oder Aussparungen im wesentlichen einen kreisförmigen Querschnitt mit einem Durchmesser auf, der mindestens das Vierfache, insbesondere mindestens das Sechsfache der Materialstärke der Glasplatte beträgt.

Die Erfindung wird nun anhand der in den Zeichnungen Dargestellten Ausführungsbeispiele erläutert.

Es zeigen:
- Fign. 1 a bis 1 e:: eine Reihenfolge von Fertigungsschritten zur Herstellung von erfindungsgemäßen Drucksensors mit erfindungsgemäßen Gegenkörpern im Waferverband;
- Fig. 2:: einen Längsschnitt durch ein Ausführungsbeispiel von erfindungsgemäßen Differenzdrucksensoren Im Waferverband vor deren Vereinzelung;
- Fig. 3:: Messdaten für Konturen der erfindungsgemäßen Gegenkörper,
- Fig. 4:: eine Rasterkraftmikroskopabbildung eines KristobalitKristalls auf der Gegenkörperoberfläche;
- Fig. 5:: ein Röntgendiffraktogramm einer Gegenkörperoberfläche nach dem Stand der Technik; und
- Fig. 6:: ein Röntgendiffraktogramm einer Gegenkörperoberfläche gemäß der vorliegenden Erfindung.

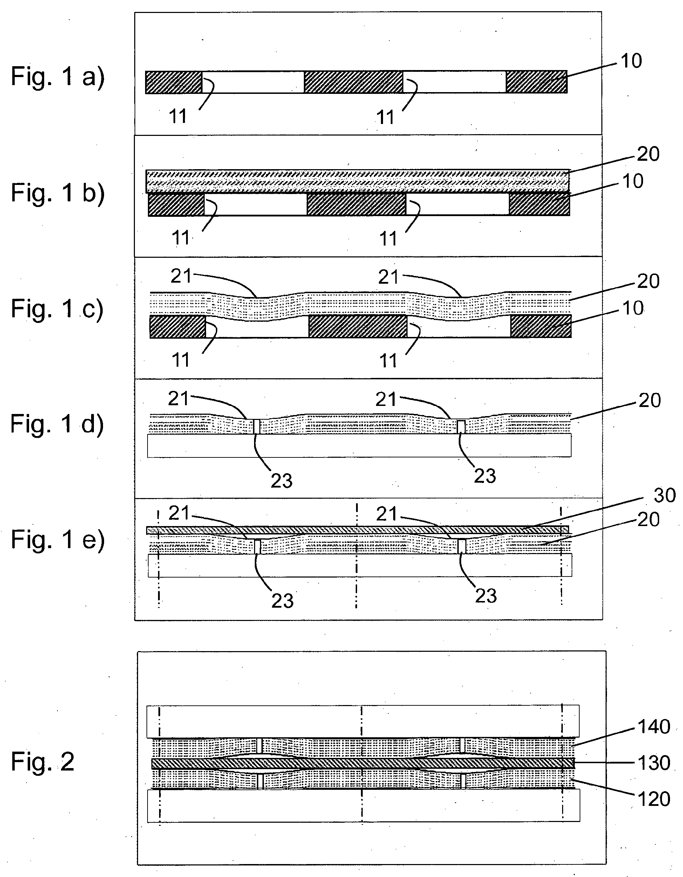

Zunächst wird das Prinzip der Präparation von Gegenkörpern und Drucksensoren anhand der Schrittfolge in Fign 1a bis 1e kurz erläutert. Die dargestellte Reihenfolge von Fertigungsschritten beginnt in Schritt (a) mit einem Graphit-Trägerkörper 10 mit einer Stärke von einigen 100 µm, in welchen in einem ersten Schritt Vertiefungen 11 präpariert werden. Die Vertiefungen 11 können beispielsweise durch (Ultraschall-)Bohren gefertigt werden. Auf Präzision kommt es bei der Fertigung der Vertiefungen nur insoweit an, als die Vertiefungen 11 nicht das Verhalten des nicht unterstützten Bereichs eines plattenförmigen Glaskörpers während der folgenden Präparationsschritte beeinträchtigen dürfen. In einer Grundvariante des erfindungsgemäßen Verfahrens bedeutet dies lediglich, dass die Querschnittsfläche der Vertiefung bzw. Aussparung zur angestrebten Form der Kontur der Gegenkörper passen muss, welche wiederum aus der derzeit bevorzugten Kreissymmetrie für die Messmembranen folgt. Die Vertiefungen 11 können einen Durchmesser von einigen mm, beispielsweise 3 bis 10 mm, vorzugsweise 4 bis 7 mm aufweisen. Im Beispiel beträgt der Durchmesser etwa 6 mm.

In einem zweiten Schritt (b) wird eine Glasplatte 20 mit einer Stärke von einigen 100 µm auf den Graphit-Trägerkörper 10 aufgebracht, wobei die Glasplatte unter Reinraumbedingungen lose auf den Siliziumwafer aufgelegt wird. Die Glasplatte weist ein Borosilikatglas auf, beispielsweise Borofloat 33. Im Ausführungsbeispiel weist die Glasplatte eine Stärke von etwa 800 µm auf.

In einem dritten Schritt (c) wird der Stapel mit dem Substratkörper 10 und der Glasplatte 20 über einen Zeitraum etwa 1,5 h von Raumtemperatur in einem Vakuumofen bei einem Druck von nicht mehr als 10⁻⁴ mbar insbesondere nicht mehr als 10⁻⁵ mbar auf 750°C geheizt und dann für etwa 5 h bei dieser Temperatur gehalten. In dieser Zeit sinkt einerseits der nicht unterstützte Bereich der Glasplatte hinreichend tief ab, wobei eine Kontur 21 mit einer Tiefe von etwa 12 µm bis etwa 16 µm entsteht die als Membranbett zum Abstützen einer Messmembran im Überlastfall geeignet ist. Anschließend kann der Stapel über mehrere Stunden abkühlen.

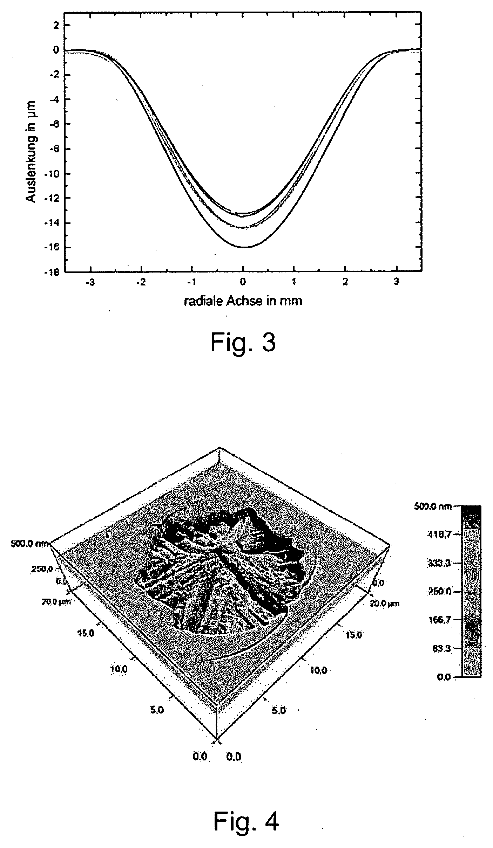

Die so präparierten Konturen wurden mit einem mechanischen Mikrotaster vermessen, wobei die Messergebnisse in Fig 3 dargestellt sind. Die dort gezeigten Konturquerschnitte bestätigen, dass sich mit der beschriebenen Präparationsmethode Konturen 21 präparieren lassen die im wesentlichen einem Biegelinienverlauf der Form (1-(r/r₀)²)² genügen, wie sie für am Rand eingespannte, kreisplattenförmige Membranen zutreffend ist.

In einem vierten Schritt (d) wird der Glaskörper vom Graphit-Trägerkörper 10 genommen, und die Unterseite des Glaskörpers 20 wird plan geschliffen, um die zu den Konturen 21 komplementären Ausbeulungen einzuebnen. Zudem werden, beispielsweise mittels Ultraschallbohren oder Lasern Kanäle 23 durch den Glaskörper 20 präpariert, welche insbesondere durch den Scheitelpunkt der Konturen 21 verlaufen und dazu dienen, beim fertig gestellten Sensor einen Druck durch den Glaskörper 20 zu führen.

In einem fünften Schritt (e) wird ein Messmembranwafer 30, der insbesondere Silizium aufweist, mittels anodischen Bondens mit dem Glaskörper 20 im Waferverband verbunden. Anschließend können die hier dargestellten Relativdrucksensoren durch Sägen entlang der dargestellten senkrechten Linien vereinzelt werden.

Selbstverständlich umfassen die Drucksensoren einen hier nicht dargestellten Wandler zum Bereitstellen eines druckabhängigen elektrischen Signals, beispielsweise einen kapazitiven Wandler, wozu ein Teil der Oberfläche der Konturen metallisiert sein kann, um eine erste Messelektrode zu bilden. Membranseitige, zweite Messelektroden können durch Dotierung des Membranwafers oder Metallisierung jeweils eines Teils des Messmembran präpariert werden, bevor der Glaskörper mit dem Glaskörpers gefügt wird. Die Kontaktierungen der Elektroden sind mit den gängigen Methoden der Mikrosystemtechnik vorzunehmen.

Fig. 2 zeigt einen Längsschnitt durch erfindungsgemäße Differenzdrucksensoren vor deren Vereinzelung. Zur Herstellung von Differenzdrucksensoren wird ein Membranwafer 130, welcher Silizium aufweist, zwei Glaskörpern 120, 140 im Waferverband mittels anodischen Bondens befestigt. Die Glaskörper 120, 140 werden zuvor jeweils im Waferverband entsprechend den Präparationsschritten a bis d aus Fig.1 gefertigt. Einzelne Differenzdrucksensoren werden schließlich durch Vereinzelung entlang der vertikalen gestrichelten Linien erhalten.

Ein solchermaßen präparierter Differenzdrucksensor kann beispielsweise mit einer Si Messmembran in einer Stärke von 30 µm einen Messbereich von 10 mbar bei einer Überlastfestigkeit gegen einseitige Überlasten von mehr als 100 bar, insbesondere mehr als 150 bar aufweisen, da die Messmembran an der Kontur eines Gegenkörpers zur Anlage kommt und abgestützt wird. Hinsichtlich des Wandlers gelten die Ausführungen zum Ausführungsbeispiel aus Fig. 1 entsprechend, wobei insbesondere die Konturen auf beiden Seiten der Messmembran eine Messelektrode aufweisen können, deren Kapazität C₁, C₂ gegen eine Membranelektrode zu messen ist. Ein Maß für den Druck kann dann eine Funktion der Differenz der Kapazitäten geteilt durch die Summe der Kapazitäten sein, also p = p((C₁ - C₂) / (C₁ + C₂)).

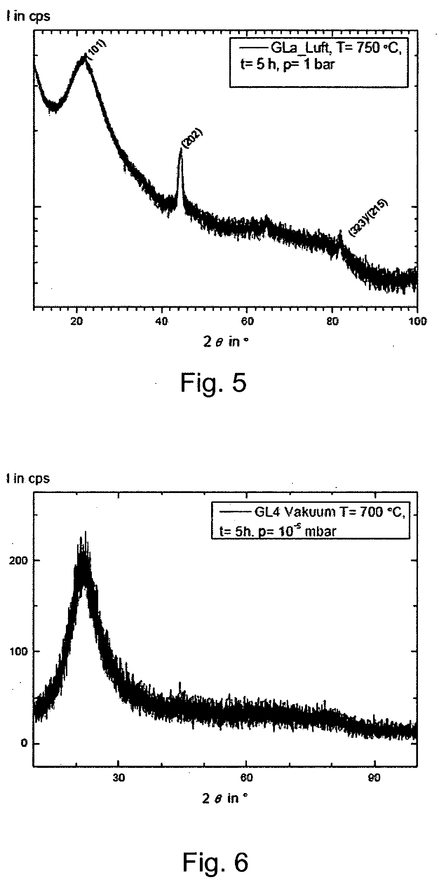

Es hat sich gezeigt, dass sich durch den Prozess des thermischen Einsinkens an der Oberfläche des Glaskörpers Defekte ausbildeten, die einen Durchmesser von bis zu 25 µm aufweisen und um bis zu mehr als 100 nm aus der Oberfläche herausragen können. Eine Rasterkraftmikroskopabbildung eines solchen Defekts ist in Fig. 4 dargestellt. Mittels Röntgendiffraktometrie wurden diese Defekte als Kristobalit identifiziert. Messdaten dazu sind in Fig. 5 dargestellt.

Derart defektfbehaftete Glasoberflächen können zu lokalen Spannungsspitzen beim Fügen führen. Es ist daher erstrebenswert, die Defekte zu vermeiden.

Um zur Vermeidung der Defekte die Kristobalitbildung zu unterdrücken bzw. zu verringern, wurde daraufhin die Präparation der Konturen im Glaskörper durch thermisches Einsinken unter Vakuum von 10⁻⁵ mbar durchgeführt. Die erhaltenen Oberflächen waren frei von den zuvor beschriebenen Defekten, was sich durch visuelle Inspektion und durch Röntgendiffraktometrie ergab. Die Ergebnisse der Röntgendiffraktometrie sind in Fig. 6 dargestellt, worin die charakteristische Signatur für Kristobalit fehlt. Die Glaskörper mit den unter Vakuum präparierten Konturen ließen sich problemlos mittels anodischen Bondens mit Siliziumwafern fügen.

Selbstverständlich lassen sich mit dem beschriebenen Verfahren Glaskörper auch zu anderen Zwecken plastisch verformen, wenn es auf eine defektfreie Oberfläche und insbesondere die Eignung zum Verbinden mit anderen Körpern ankommt, beispielsweise mit Halbleiterwafern mittels anodischen Bondens.

## Patentansprüche

1. Druckmesszelle, umfassend mindestens einen Gegenkörper (20) und eine in der Gleichgewichtslage ebene Messmembran (30), welche insbesondere mittels anodischen Bondens mit dem mindestens einen Gegenkörper (20) entlang einer umlaufenden Fügestelle druckdicht gefügt ist, wobei der Gegenkörper (20) ein Borosilikatglas aufweist, wobei der Gegenkörper eine Glasoberfläche mit einem planaren Randbereich umfasst, der mit der Messmembran gefügt ist, wobei der Randbereich eine ihm gegenüber vertiefte Kontur (21) umgibt, welche die Biegelinie der mit ihm zu fügenden Messmembran approximiert, um die Messmembran (30) im Falle einer Überlast abzustützen,
**dadurch gekennzeichnet, dass**
die Oberfläche eine Oberflächenrauheit Rₐ < 100 nm aufweist, und
dass die Oberfläche frei von Kristobalit-Kristallen ist, die einen Durchmesser von mehr als 5 µm aufweisen,
wobei die vertiefte Kontur durch thermisches Einsinken eines Glaskörpers erhältlich ist, wobei das thermische Einsinken bei einem Druck von nicht mehr als 10⁻⁴ mbar, insbesondere nicht mehr als 10⁻⁶ mbar erfolgt,
wobei durch das thermische Einsinken eine Einsinktiefe z₀ der Konturen erzielt wird, die nicht weniger als 0,2% und nicht mehr als 10% der Materialstärke, insbesondere nicht weniger als 0,5% und nicht mehr als 5% der Materialstärke des Glaskörpers, beträgt.

2. Druckmesszelle nach einem der vorhergehenden Ansprüche, wobei ein Fit einer Funktion der Form z(r)= z₀*(1-(r/r₀)²)² an die durch den planaren Randbereich begrenzte. Kontur (21) einen Wert von z₀ ergibt, für den gilt: z₀/r₀ > 2*10⁻³, insbesondere z₀/r₀ > 3*10⁻³ und bevorzugt z₀/r₀ 4*10⁻³, wobei r₀ ein effektiver äußerer Radius der Kontur ist.

3. Druckmesszelle nach Anspruch 1 oder 2,
wobei die Druckmesszelle eine Differenzdruckmesszelle ist und weiterhin einen zweiten Gegenkörper (140) nach einem der Ansprüche 1 bis 2 umfasst, und wobei die Messmembran (130) zwischen dem ersten Gegenkörper (120) und dem zweiten Gegenkörper (140) angeordnet und mit beiden Gegenkörpern druckdicht gefügt ist.

4. Druckmesszelle nach Anspruch einem der Ansprüche 1 bis 3, wobei die Messmembran Silizium aufweist.

5. Verfahren zum Herstellen einer Vielzahl von Gegenkörpern für Druckmesszellen nach einem der Ansprüche 1 bis 4,
welches das plastische Verformen eines plattenförmigen Glaskörpers, welcher ein Borosilikatglas aufweist, mit den folgenden Schritten umfasst:
Positionieren des Glaskörpers auf einem Träger welcher den Glaskörper in mehreren Bereichen nicht unterstützt,
und Erwärmen des Glaskörpers, so dass eine plastische Verformung der nicht unterstützten Bereiche durch thermisches Einsinken der nicht unterstützten Bereiche erfolgt,
wobei aus dem plattenförmigen Glaskörper, die Vielzahl der Gegenkörper zu präparieren ist, und wobei der Träger, auf dem der Glaskörper zu positionieren ist, eine Vielzahl von Aussparungen oder Vertiefungen aufweist, über denen jeweils ein nicht unterstützter Bereich des Glaskörpers angeordnet ist, dessen plastische Verformung durch thermisches Einsinken erfolgt, um jeweils eine Kontur eines Gegenkörpers zu bilden,
**dadurch gekennzeichnet,**
**dass** das thermische Einsinken bei einem Druck von nicht mehr als 10⁻⁴ mbar, Insbesondere nicht mehr als 10⁻⁵ mbar erfolgt,
wobei durch das thermische Einsinken eine Einsinktiefe z₀ der Konturen erzielt wird, die nicht weniger als 0,2% und nicht mehr als 10% der Materialstärke, insbesondere nicht weniger als 0,5% und nicht mehr als 5% der Materialstärke des Glaskörpers, beträgt.

6. Verfahren nach Anspruch 5, wobei das thermische Einsinken bei einer Temperatur oder Temperaturen erfolgt, die nicht weniger als 200°C, insbesondere nicht weniger als 250°C und bevorzugt nicht weniger als 280°C über dem Erweichungspunkt des Glases liegt bzw. liegen.

7. Verfahren nach Anspruch 5 oder 6, wobei die Vertiefungen oder Aussparungen im Wesentlichen einen kreisförmigen Querschnitt mit einem Durchmesser aufweisen, der mindestens das Vierfache. insbesondere mindestens das Sechsfache der Materialstärke der Glasplatte beträgt.

## Claims

1. Pressure measuring cell comprising at least one counter-body (20) and a measuring diaphragm (30) level in the equilibrium position, said measuring diaphragm being joined in a pressure-tight manner with the at least one counter-body (20) along a circumferential joint by means of anodic bonding, wherein the counter-body (20) has a borosilicate glass, wherein the counter-body comprises a glass surface with a planar marginal zone which is joined to the measuring diaphragm, wherein the marginal zone surrounds a recessed contour (21) situated opposite it, said contour approximating the bending line of the measuring diaphragm to be joined to the marginal zone for the purposes of supporting the measuring diaphragm (30) in the case of overload,
**characterized in that**
the surface has a surface roughness of Rₐ < 100 nm, and
the surface is free from cristobalite crystals with a diameter of more than 5 µm,
wherein the recessed contour can be obtained through the thermal subsidence of a glass body, wherein the thermal subsidence is performed at a pressure of not more than 10⁻⁴ mbar, particularly not more than 10⁻⁵,
wherein as a result of the thermal subsidence, a subsidence depth z₀ of the contour is achieved, which is not less than 0.2% and not more than 10% of the material thickness, particularly not less than 0.5 % and not more than 5% of the material thickness of the glass body.

2. Pressure measuring cell as claimed in one of the previous claims, wherein an adaptation of a function in the form of z(r = z₀*(1-r/r₀)²)² to the contour (21) delimited by the marginal zone gives a value of z₀, wherein: z₀/r₀ > 2*10⁻³, notably z₀/r₀ > 3*10⁻³ and preferably z₀/r₀ > 4*10⁻³, where r₀ is an effective outer radius of the contour.

3. Pressure measure cell as claimed in Claim 1 or 2,
wherein the pressure measuring cell is a differential pressure measuring cell and further comprises a second counter-body (140) according to one of the Claims 1 or 2, and wherein the measuring diaphragm (130) is arranged between the first counter-body (120) and the second counter-body (140), and is joined to both counter-bodies in a pressure-tight manner.

4. Pressure measure cell as claimed in one of the Claims 1 to 3,
wherein the measuring diaphragm has silicon.

5. Procedure to manufacture a multiplicity of counter-bodies for pressure measuring cells as claimed in one of the Claims 1 to 4,
said procedure comprising the plastic deformation of a plate-shaped glass body, which has a borosilicate glass, incorporating the following steps:
Positioning of the glass body on a carrier which does not support the glass body in several areas,
and warming of the glass body such that a plastic deformation of the unsupported areas takes place through the thermal subsidence of the unsupported areas,
wherein the multiplicity of counter-bodies is to be prepared from the plate-shaped glass body, and wherein the carrier on which the glass body is to be positioned features several indentations or recesses over which an unsupported section of the glass body is arranged in each case and wherein the plastic deformation of the glass body section is performed by thermal subsidence in order to form a contour of a counter-body,
**characterized in that**
the thermal subsidence is performed at a pressure of not more than 10⁻⁴ mbar, particularly not more than 10⁻⁵ mbar
wherein as a result of the thermal subsidence, a subsidence depth z₀ of the contours is achieved, which is not less than 0.2% and not more than 10% of the material thickness, particularly not less than 0.5% and not more than 5% of the material thickness of the glass body.

6. Procedure as claimed in Claim 5, wherein the thermal subsidence takes place at a temperature or temperatures not less than 200 °C, particularly not less than 250 °C and preferably not less than 280 °C over the softening point of the glass.

7. Procedure as claimed in Claim 5 or 6, wherein the recesses or indentations essentially have a circular cross-section with a diameter which is at least four times and particularly at least six times the material thickness of the glass plate.

## Revendications

1. Cellule de mesure de pression comprenant au moins un contre-corps (20) et une membrane de mesure (30) plane en position d'équilibre, laquelle membrane est notamment jointe au moyen d'une liaison anodique avec l'au moins un contre-corps (20), de façon étanche le long d'un joint périphérique, le contre-corps (20) présentant un verre borosilicaté, le contre-corps comprenant une surface de verre avec une zone marginale planaire, qui est joint à la membrane, la zone marginale entourant un contour (21) évidé situé à son opposé, lequel contour s'approche par approximation de la courbe de flexion de la membrane à joindre au contour, afin de soutenir la membrane de mesure (30) en cas de surcharge,
**caractérisée**
**en ce que** la surface présente une rugosité Rₐ < 100 nm, et
**en ce que** la surface est exempte de cristaux de cristobalite, qui présentent un diamètre de plus de 5 µm,
pour laquelle le contour évidé est obtenu par affaissement thermique d'un corps de verre, l'affaissement thermique intervenant à une pression maximale de 10⁻⁴ mbar, notamment à une pression maximale de 10⁻⁵ mbar,
pour laquelle est obtenue, par l'affaissement thermique, une profondeur d'affaissement z₀ des contours, qui représente au moins 0,2 % et au plus 10 % de l'épaisseur du matériau, notamment au moins 0,5 % et au plus 5 % de l'épaisseur du matériau du corps de verre.

2. Cellule de mesure de pression selon la revendication précédente, pour laquelle une adaptation d'une fonction de la forme z(r = z₀*(1-r/r₀)²)² au contour (21) délimité par la zone marginale planaire donne une valeur de z₀, pour laquelle s'applique : z₀/r₀ > 2*10⁻³, notamment z₀/r₀ > 3*10⁻³ et de préférence z₀/r₀ > 4*10⁻³, où r₀ est un rayon extérieur effectif du contour.

3. Cellule de mesure de pression selon la revendication 1 ou 2,
la cellule de mesure de pression étant une cellule de mesure de pression différentielle et comprenant en outre un deuxième contre-corps (140) selon l'une des revendications 1 à 2, et la membrane de mesure (130) étant disposée entre le premier contre-corps (120) et le deuxième contre-corps (140), et jointe de façon étanche aux deux contre-corps.

4. Cellule de mesure de pression selon l'une des revendications 1 à 3, pour laquelle la membrane de mesure présente du silicium.

5. Procédé destiné à la fabrication d'un grand nombre de contre-corps pour des cellules de mesure de pression selon l'une des revendications 1 à 4,
lequel procédé comprend la déformation plastique d'un corps de verre en forme de plaque, lequel corps présente un verre borosilicaté, avec les étapes suivantes :
Positionnement du corps de verre sur un support, qui ne supporte pas le corps de verre dans plusieurs zones,
et échauffement du corps de verre, de telle sorte que s'effectue une déformation plastique des zones non supportées par l'affaissement thermique des zones non supportées,
pour lequel le grand nombre de contre-corps doit être préparé à partir du corps de verre en forme de plaque, et pour lequel le support, sur lequel le corps de verre doit être positionné, présente un grand nombre d'évidements ou de creux, au-dessus desquels est disposée respectivement une zone non supportée du corps de verre, dont la déformation plastique est réalisée par affaissement thermique, afin de former un contour d'un contre-corps,
**caractérisé**
**en ce que** l'affaissement thermique intervient à une pression maximale de 10⁻⁴ mbar, notamment à une pression maximale de 10⁻⁵ mbar,
pour lequel est obtenu, par l'affaissement thermique, une profondeur d'affaissement z₀ des contours, qui représente au moins 0,2 % et au plus 10 % de l'épaisseur du matériau, notamment au moins 0,5 % et au plus 5 % de l'épaisseur du matériau du corps de verre.

6. Procédé selon la revendication 5, pour lequel l'affaissement thermique intervient à une température ou à des températures, qui ne sont pas inférieures à 200 °C, notamment pas inférieures à 250 °C et de préférence pas inférieures à 280 °C au-dessus du point de ramollissement du verre.

7. Procédé selon la revendication 5 ou 6, pour lequel les évidements ou les creux présentent pour l'essentiel une section circulaire d'un diamètre représentant au moins un multiple, notamment au moins le sextuple de l'épaisseur du matériau de la plaque de verre.
